# EUROPEAN PATENT APPLICATION

(11) **EP 2 138 874 A1**
(43) Date of publication of application: **30.12.2009**
(21) Application number: 09173256.0
(22) Date of filing: 11.07.2008
(51) Int. Cl.: G02B 6/00

(54) **Led lighting fixture**

(30) Priority: 13.09.2007 TW 96215457 U
(62) Divisional of application: 08160179.1
(71) Applicant: Kun Dian Photoelectric Enterprise Co., Lujhou City 247 (TW)
(72) Inventor: Lee, Cheng Sheng, Lujhou City 247 (TW)
(74) Representative: Viering, Jentschura & Partner

(57) **Abstract**

A LED lighting fixture includes a light guide board, which is made of a high transmissive material and directly mounted in the cavity of a lamp holder, furniture, utensil, or the construction of a building, having a clear base layer (21) at the front side and a continuous piece of reflective layer (3) at the back side, and a plurality of LEDs (4) mounted within the cavity (11) outside the light guide board and controlled to emit light transversely into the inside of the light guide boards for reflection by the reflective layer to increase the angle of illumination and to provide a uniform lighting effect having an enhanced brightness without multi-image and flashing.

## Description

### BACKGROUND OF THE INVENTION

### 1. Field of the Invention:

The present invention relates to lighting fixtures and more specifically, to a LED lighting fixture, which uses a light guide board having a corrugated cross section and covered with a reflective layer to guide light from LEDs so as to increase the angle of illumination and to provide a uniform lighting effect having an enhanced brightness without multi-image and flashing.

### 2. Description of the Related Art:

The history of lamp extends for long. Since the invention of lamp to produce light, it greatly improves the living style of people. Nowadays, a variety of lighting fixtures of different outer appearances have been disclosed for different purposes. Because of heavy market demand, improvements on function as well as on application should never stop.

Despite of different design changes, conventional lighting fixtures use a lamp bulb or lamp tube to produce light. These conventional lighting fixtures have the common drawbacks of high consumption of electric energy and production of heat. The production of heat greatly not only shortens the service life of the lighting fixture but also increases the ambient temperature. Further, a daylight lamp causes a flashing problem that is harmful to the eyes.

Nowadays, LEDs (light emitting diodes) have been intensively used in lighting fixtures to substitute for conventional lamp bulbs and tubes for the advantages of low power consumption and long service life. Further, because LEDs do not contain mercury, using LEDs for lighting fixture brings no harm to environment.

However, LEDs may be too dim in bright light situations because of its unidirectional lighting feature. Therefore, a LED lighting fixture has the drawback of limited angle of illumination. To overcome this problem, multiple LEDs may be arranged together and set in different angles. However, this arrangement greatly complicates the fabrication of the lighting fixture and will also increase the cost. Further, a lighting fixture constructed according to this arrangement may produce multiple images, not practical to substitute for conventional daylight lamps.

Taiwan Patent Publication No. M306666 discloses a light guide structure for lighting fixture, which is an invention of the present inventor. According to this design, the light guide structure comprises a light guide board made of a transmissive material having a clear transmissive layer, and a reflective layer covered on the back side of the light guide board. The reflective layer has an arched convex portion on the middle (see claim 7). The light guide structure is used with a lateral light source to construct a lighting fixture that increases the angle of illumination, provides a uniform lighting effect with enhanced brightness, and eliminates the multi-image and flashing problems of conventional daylight lamps.

However, the design of the arched convex portion of the reflective layer still has a limitation in reflection. Therefore, there is still a room for improvement.

### SUMMARY OF THE INVENTION

The present invention has been accomplished under the circumstances in view and is described in the claims. It is the main object of the present invention to provide a LED lighting fixture formed of a light guide board and a set of LEDs, which has a curved reflective layer provided at the light guide board to produce a satisfactory reflection effect, thereby effectively increasing the angle of illumination, providing a uniform lighting effect with enhanced brightness, and eliminating the multi-image and flashing problems of conventional daylight lamps.

To achieve this and other objects of the present invention, the LED lighting fixture comprises a cavity directly formed in a lamp holder, furniture, utensil, or the construction of a building, a light guide board, and a plurality of LEDs (light emitting diodes). The light guide board is made of a high transmissive material, comprising a clear base layer at the front side and a continuous piece of reflective layer at the back side. The reflective layer has a corrugated cross section. The LEDs are mounted within the cavity outside the light guide board, and adapted to emit light transversely into the inside of the light guide board for reflection by the reflective layer to increase the angle of illumination and to provide a uniform lighting effect having an enhanced brightness without causing multi-image and flashing.

### BRIEF DESCRIPTION OF THE DRAWINGS

FIG. 1 is a schematic plain view of a LED lighting fixture in accordance with the first embodiment of the present invention.
FIG. 2 is a schematic plain view of the first embodiment of the present invention, showing the lighting fixture installed in the cavity of a lamp holder.

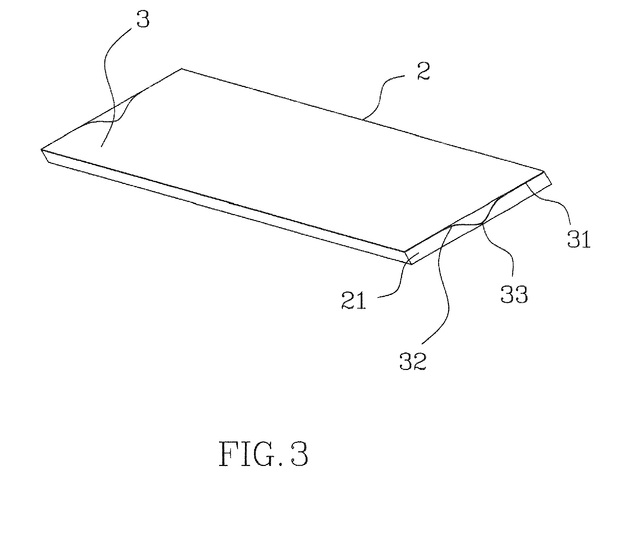

FIG. 3 is an elevational view of a light guide board for the LED lighting fixture in accordance with the first embodiment of the present invention.

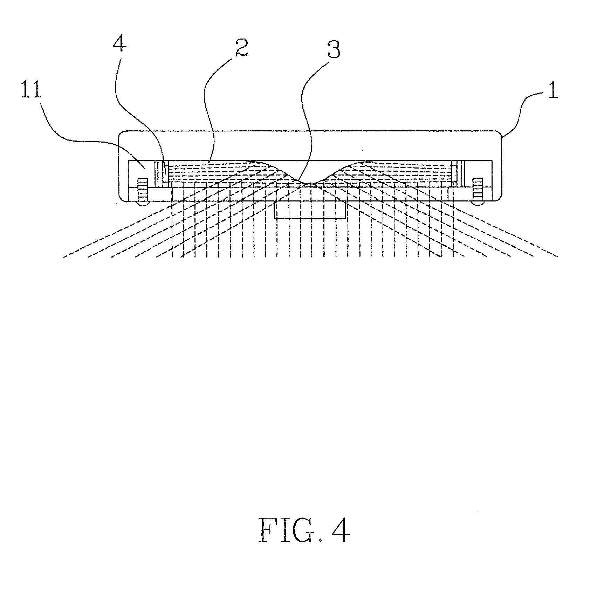

FIG. 4 is a schematic drawing showing an application example of the LED lighting fixture in accordance with the first embodiment of the present invention.
FIG. 5 is a plain view of a part of the first embodiment of the present invention, showing the clear base layer of the light guide board provided with reinforcing grooves.
FIG. 6 is a schematic plain view of a LED lighting fixture in accordance with a second embodiment of the present invention.
FIG. 7 is a schematic plain view of the second embodiment of the present invention, showing the lighting fixture installed in the cavity of a lamp holder.

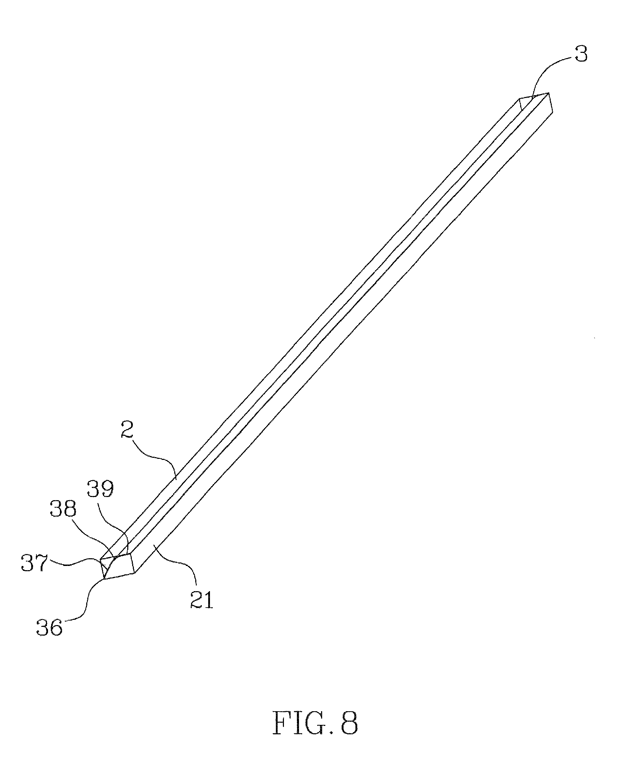

FIG. 8 is a perspective view of a light guide board for the LED lighting fixture in accordance with the second embodiment of the present invention.

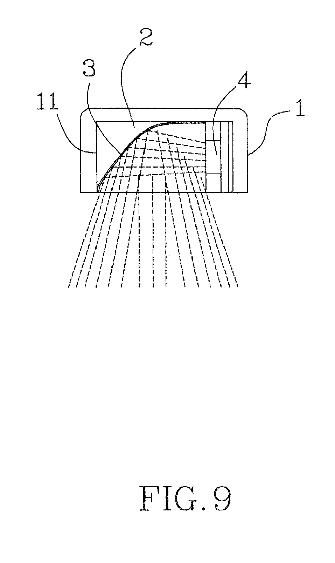

FIG. 9 is a schematic drawing showing an application example of the LED lighting fixture in accordance with the second embodiment of the present invention.
FIG. 10 is a plain view of a part of the second embodiment of the present invention, showing the clear base layer of the light guide board provided with a reinforcing groove.
FIG. 11 is a schematic plain view of the second embodiment of the present invention, showing multiple LED lighting fixtures arranged in parallel in one single cavity according to the present invention.

### DETAILED DESCRIPTION OF THE PREFERRED EMBODIMENT

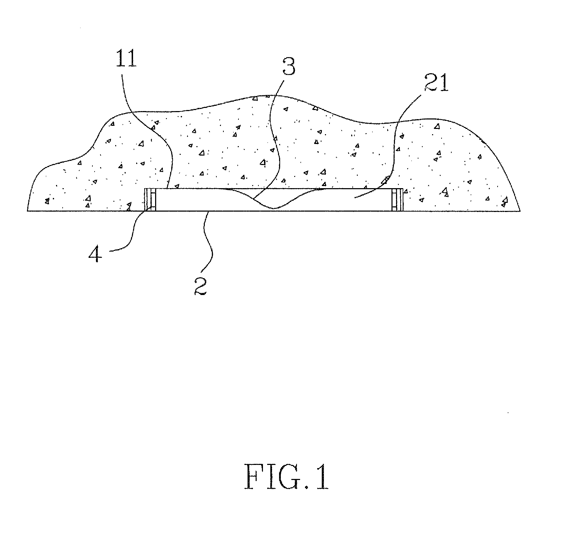

Referring to FIGS. 1∼5, a LED lighting fixture in accordance with a first embodiment of the present invention is shown comprising a cavity **11**, a light guide board **2,** and a plurality of LEDs (light emitting diodes) **4.**

The cavity **11** may be directly formed in a lamp holder **1,** a piece of furniture, a utensil, or the construction of a building.

The light guide board **2** is made of a high transmissive material and mounted inside the cavity **11,** having a clear base layer **21** at its front side a continuous piece of reflective layer **3** at its back side. The cross section of the reflective layer **3** shows a corrugated pattern. Further, the reflective layer **3** has two straight end edges **31,** two arched shoulder portions **32** respectively extended from the two straight end edges **31** on the middle and respectively terminating in a V-shaped tip **33.**

The LEDs **4** are mounted within the cavity **11** outside the light guide board **2,** and adapted to emit light transversely into the inside of the light guide board **2** from two opposite lateral sides.

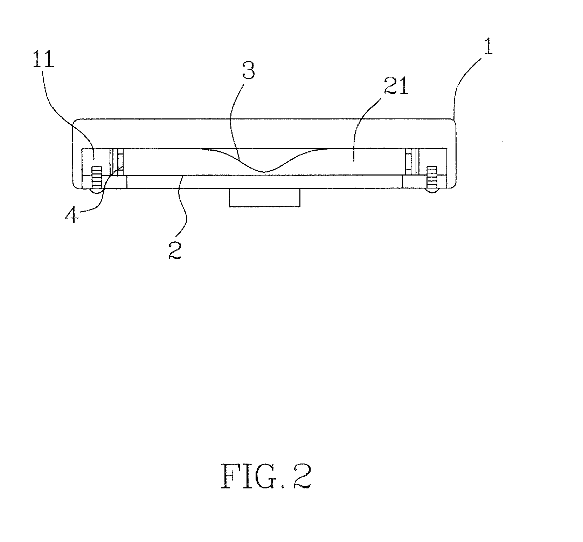

Referring to FIGS. 2∼4 again, when the LED lighting fixture is turned on, the LEDs **4** emit light toward the inside of the light guide board **2** from two opposite lateral sides. When light rays go through the light guide board **2,** the straight end edges **31,** arched shoulder portions **32,** V-shaped tips **33** and corrugated cross section of the reflective layer **3** reflect the light rays from the LEDs **4** in different directions, increasing the angle of illumination, providing a uniform lighting effect and enhancing the brightness and eliminating the multi-image and flashing problems of the prior art design.

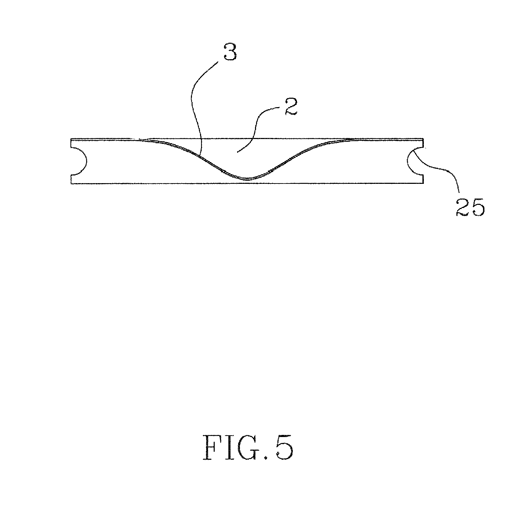

Referring to FIGS. 2 and 5 again, the light guide board **2** can be made having two reinforcing grooves **25** respectively disposed on the two opposite lateral side edges and extending along the length to reinforce the structural strength, preventing deformation of the light guide board **2** during installation. Further, during installation of the LED lighting fixture, the LEDs **4** can be inserted into the reinforcing grooves **25,** so that light rays from the LEDs **4** directly go through the light input surface **22** toward the reflective layer, eliminating light leakage and obtaining the best lighting effect.

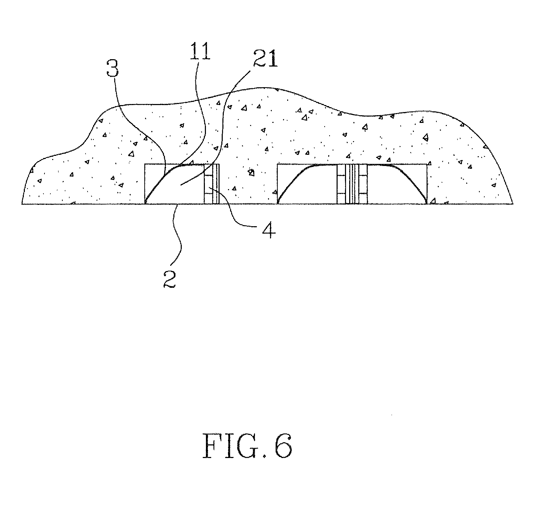

Referring to FIGS. 6∼10, a LED lighting fixture in accordance with a second embodiment of the present invention is shown comprising a cavity **11,** a light guide board **2,** and a plurality of LEDs (light emitting diodes) **4.**

The cavity **11** may be directly formed in a lamp holder **1,** a piece of furniture, a utensil, or the construction of a building.

The light guide board **2** is made of a high transmissive material and mounted inside the cavity **11,** having a clear base layer **21** at its front side a continuous piece of reflective layer **3** at its back side. The clear base layer **21** of the light guide board **2** has a light input surface **22** disposed at one lateral side, and a light output surface **23** disposed at the front side and abutted against the light output surface **23** at an angle. The reflective layer **3** h as a corrugated cross section, and an inner side bonded to the whole surface area of said clear base layer **21** beyond the light input surface **22** and the light output surface **23.** The inner side of the reflective layer **3** that is bonded to the clear base layer **21** has a flat base portion **39** disposed close to the light source (the LEDs **4),** a curved tail portion **36** abutted against one side of the light output surface **23** opposite to the light input surface **22**, a sloping portion **37** connected between the flat base portion **39** and the tail portion **36,** and a great arched portion **38** connected between the flat base portion **39** and the sloping portion **37.**

The LEDs **4** are mounted within the cavity **11** outside the light guide board **2,** and adapted to emit light through the light input surface **22** into the inside of the light guide board **2.**

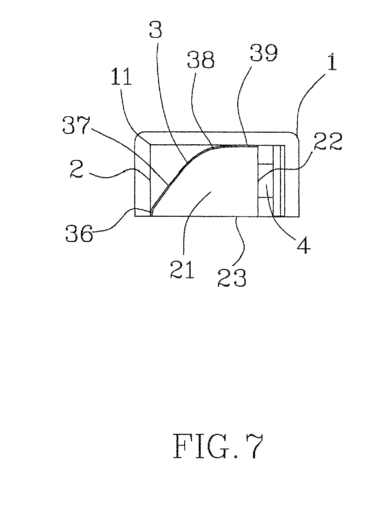

Referring to FIGS. 7∼9 again, when the LED lighting fixture is turned on, the LEDs **4** emit light through the light input surface **22** into the inside of the light guide board **2.** When light rays go through the light input surface **22** into the inside of the light guide board **2,** the incident light rays are reflected by the flat base portion **39,** the great arched portion **38,** the sloping portion **37** and the tail portion **36** in different angles toward the outside of the light guide board **2** and the cavity **11** through the light output surface **23** to increase the angle of illumination, thereby providing a uniform lighting effect and enhancing the brightness and eliminating the multi-image and flashing problems of the prior art design.

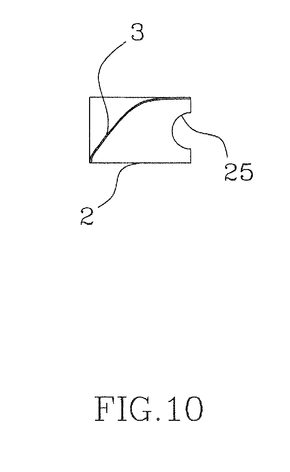

Referring to FIGS. 6 and 10 again, the light guide board **2** can be made having a reinforcing groove **25** formed on and extending along the length of its one side to reinforce the structural strength of the light guide board **2** a gainst deformation. Further, during installation of the LED lighting fixture, the LEDs **4** can be inserted into the reinforcing groove **25,** so that light rays from the LEDs **4** directly go through the light input surface **22** toward the reflective layer, eliminating light leakage and obtaining the best lighting effect.

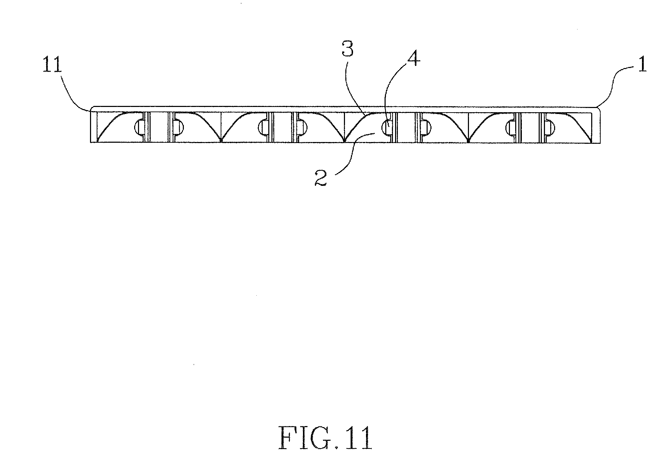

Further, as shown in FIG. 11, it is to be understood that the arrangement of this new structure is for single-side illumination. Therefore, the structure can be made relatively greater to replace for a daylight lamp, i.e., multiple sets can be arranged in parallel in one same cavity **11** or lamp holder **1** for use to substitute for a conventional embedded ceiling lamp, providing a satisfactory lighting effect.

A first further aspect of the invention includes an LED lighting fixture comprising a cavity, a light guide board made of a transmissive material and mounted inside said cavity, said light guide board comprising a clear base layer at a front side thereof and a continuous piece of reflective layer at a back side thereof, said reflective layer having a corrugated cross section, said reflective layer comprising two straight end edges, two arched shoulder portions respectively extended from said two straight end edges on the middle and respectively terminating in a V-shaped tip; and a plurality of LEDs mounted within said cavity outside said light guide board and adapted to emit light transversely into the inside of said light guide board from two opposite lateral sides for reflection by said reflective layer to increase the angle of illumination and to provide a uniform lighting effect having an enhanced brightness without causing multi-image and flashing.

A second further aspect of the invention includes an LED lighting fixture comprising a lamp holder, the lamp holder defining therein a cavity, and a light guide board made of a transmissive material and mounted inside said cavity, said light guide board comprising a clear base layer at a front side thereof and a continuous piece of reflective layer at a back side thereof, said reflective layer having a corrugated cross section, said reflective layer comprising two straight end edges, two arched shoulder portions respectively extended from said two straight end edges on the middle and respectively terminating in a V-shaped tip, and a plurality of light emitting diodes mounted within said cavity outside said light guide board and adapted to emit light transversely into the inside of said light guide board from two opposite lateral sides for reflection by said reflective layer to increase the angle of illumination and to provide a uniform lighting effect having an enhanced brightness without causing multi-image and flashing.

A third further aspect of the invention is an LED lighting fixture according to either the first or second aspect in which said clear base layer of said light guide board comprises two reinforcing grooves extending along two opposite lateral sides in a parallel manner.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A LED lighting fixture comprising:
a cavity;
a light guide board made of a transmissive material and mounted inside said cavity, said light guide board comprising a clear base layer at a front side thereof and a continuous piece of reflective layer at a back side thereof, said clear base layer comprising a light input surface disposed at one lateral side thereof and a light output surface disposed at a front side thereof and abutted against said light output surface at an angle, said reflective layer having a corrugated cross section and an inner side bonded to the whole surface area of said clear base layer beyond said light input surface and said light output surface, the inner side of the reflective layer comprising a flat base portion disposed abutted to one side of said light input surface, a curved tail portion abutted against one side of said light output surface opposite to said light input surface, a sloping portion connected between said flat base portion and said tail portion, and a great arched portion connected between said flat base portion and said sloping portion; and
a plurality of light emitting diodes mounted within said cavity outside said light guide board and adapted to emit light through said light input surface into the inside of said light guide board for reflection by said reflective layer toward said light output surface to increase angle of illumination and to provide a uniform lighting effect having an enhanced brightness without causing multi-image and flashing.

2. A LED lighting fixture comprising:
a lamp holder, said lamp holder defining therein a cavity;
a light guide board made of a transmissive material and mounted inside said cavity, said light guide board comprising a clear base layer at a front side thereof and a continuous piece of reflective layer at a back side thereof, said clear base layer comprising a light input surface disposed at one lateral side thereof and a light output surface disposed at a front side thereof and abutted against said light output surface at an angle, said reflective layer having a corrugated cross section and an inner side bonded to the whole surface area of said clear base layer beyond said light input surface and said light output surface, the inner side of the reflective layer comprising a flat base portion disposed abutted to one side of said light input surface, a curved tail portion abutted against one side of said light output surface opposite to said light input surface, a sloping portion connected between said flat base portion and said tail portion, and a great arched portion connected between said flat base portion and said sloping portion; and
a plurality of light emitting diodes mounted within said cavity outside said light guide board and adapted to emit light through said light input surface into the inside of said light guide board for reflection by said reflective layer toward said light output surface to increase angle of illumination and to provide a uniform lighting effect having an enhanced brightness without causing multi-image and flashing.

3. The LED lighting fixture as claimed in claim 1 or 2, wherein said clear base layer of said light guide board comprises a reinforcing groove extending along the length of said light input surface.

4. The LED lighting fixture as claimed in claim 1 or 2, wherein said cavity accommodates parallel sets of light guide boards and light emitting diodes.
